# EUROPEAN PATENT APPLICATION

(11) **EP 4 213 180 A2**
(43) Date of publication of application: **19.07.2023**
(21) Application number: 22213451.2
(22) Date of filing: 14.12.2022
(51) Int. Cl.: H01L 21/027, H01L 21/033, H01L 21/56, H01L 21/683, H01L 21/78, H01L 23/31, H01L 23/00

(54) **CHIP-SCALE PACKAGE**

(30) Priority: 14.01.2022 EP 22151541
(71) Applicant: Nexperia B.V., 6534 AB Nijmegen (NL)
(72) Inventor: Poelma, Regnerus Hermannus, Nijmegen (NL); Bünning, Hartmut, 22529 Hamburg (DE); Berglund, Stefan, 22529 Hamburg (DE); Funke, Hans-Juergen, 22529 Hamburg (DE); Kuipers, Johannes Josinus, 6534 AB Nijmegen (NL); Stokkermans, Joep, 6534 AB Nijmegen (NL); Schnitt, Wolfgang, 22529 Hamburg (DE)
(74) Representative: Pjanovic, Ilija

(57) **Abstract**

Aspects of the present disclosure relate to a semiconductor device such as a chip-scale package. Aspects of the present disclosure further relate to a method for manufacturing such a device.

According to an aspect of the present disclosure, a semiconductor device is provided that comprises a conformal coating arranged on its sidewalls and on the perimeter part of the semiconductor die of the semiconductor device. To prevent the conformal coating from covering unwanted areas, such as electrical terminals, a sacrificial layer is arranged prior to arranging the conformal coating. By removing the sacrificial layer, the conformal coating can be removed locally. The conformal coating covers the perimeter part of the semiconductor die comprises by the semiconductor device, in which part a remainder of a sawing line or dicing street is provided.

## Description

### FIELD

Aspects of the present disclosure relate to a chip-scale package comprising a vertical semiconductor device. Aspects of the present disclosure further relate to a method for manufacturing such a package. Within the context of the present disclosure, a vertical semiconductor device should be construed as a device comprising a semiconductor die, wherein the device comprises device terminals on opposite sides of the semiconductor die by which electrical signals can be supplied to and/or extracted from the device. Furthermore, within the context of the present disclosure, a chip-scale package corresponds to a direct surface mountable package of which the dimensions substantially correspond to the dimensions of the single semiconductor die comprised by it.

### BACKGROUND

Semiconductor devices are normally manufactured in large quantities at the same time. For example, a semiconductor wafer may be used that is divided into a plurality of substantially identical segments, wherein each semiconductor device is realized using a respective segment.

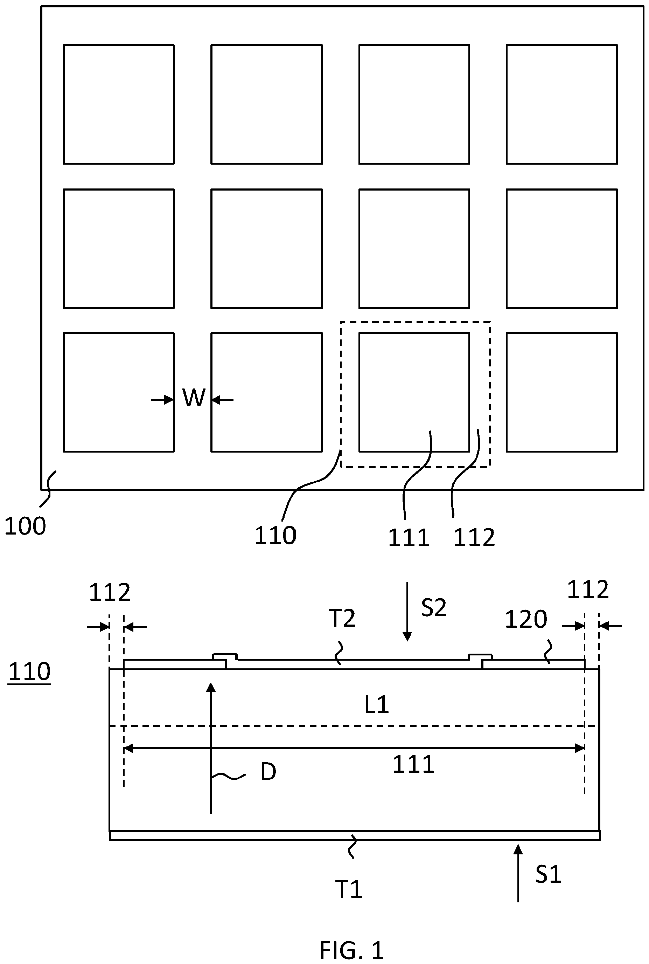

An example of such segmentation is shown in figure 1 (top). Here, part of a semiconductor wafer 100 is shown that is divided into segments 110. Each segment 110 comprises an inner part 111 and a perimeter part 112. The actual device is realized inside inner part 111, whereas perimeter part 112 comprises a sawing line or dicing street for singulating the various segments 110. After at least partial singulation, the segments are also referred to as semiconductor dies.

An exemplary cross-section of a semiconductor die obtained from semiconductor wafer 100 is shown in figure 1 (bottom). Here, semiconductor die 110 constitutes a two-terminal diode having a first terminal T1 arranged on a first surface S1 and a second terminal T2 arranged on a second surface S2 opposite to first surface S1. A normal direction D can be identified as extending perpendicular to and from first surface S1 to second surface S2.

As shown in figure 1 (bottom), inner part 111 of semiconductor die 110 comprises one or more electrically insulating layers 120, hereinafter collectively referred to as passivation layer. Second terminal T2 is exposed through one or more openings in passivation layer 120. Passivation layer 120 is not or not fully present in perimeter part 112 of semiconductor die 110.

Perimeter part 112 of semiconductor die 110 comprises a remainder of a sawing line or dicing street, preferably around all sides of inner part 111. When semiconductors dies 110 are singulated, for example by sawing through the sawing lane, material from perimeter part 112 of the corresponding segment 110 is removed. Consequently, perimeter part 112 of a segment 110 prior to dicing or sawing is larger than perimeter part 112 of semiconductor die 110.

Semiconductor die 110 may form a vertical PN diode with a p-type doped region arranged above dashed line L1, and an-type doped region arranged below dashed line L1.

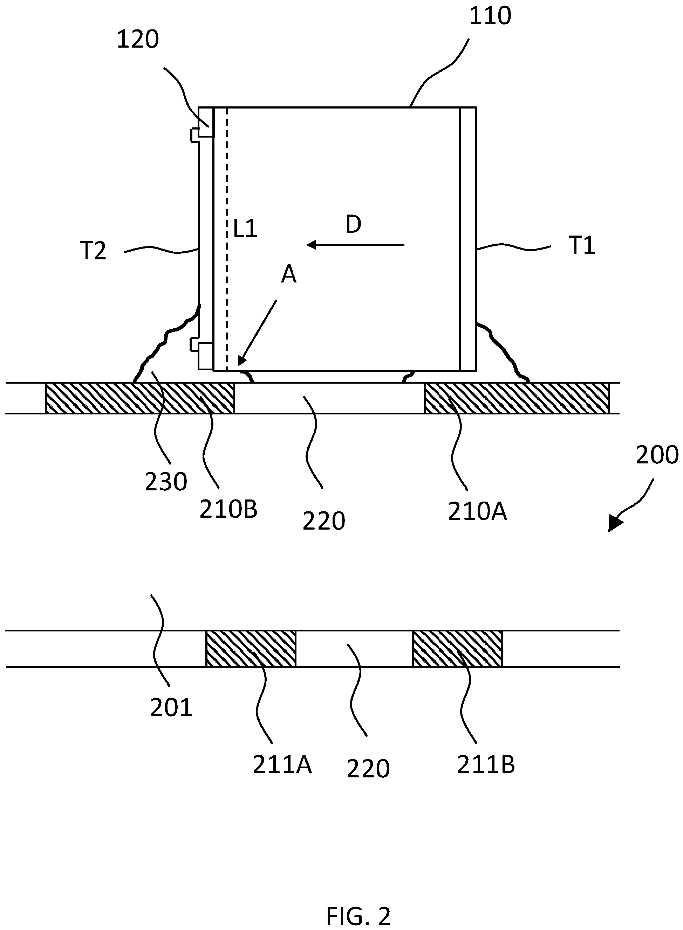

Semiconductor dies of the type shown in figure 1 cannot always be used as chip-scale packages. For example, when mounting semiconductor die 110 on a carrier, such as a printed circuit board, a risk of short-circuiting may exist. This is explained next in connection with figure 2.

Figure 2 (top) illustrates a semiconductor die 110 of the type shown in figure 1 arranged as a chip-scale package mounted on a printed circuit board 200. As shown, normal direction D is parallel to printed circuit board 200.

Printed circuit board 200 comprises a dielectric layer 201 that is covered on both sides with metal traces 210A, 210B, 211A, 211B. For example, on its top surface, printed circuit board 200 comprises a first contact pad 210A, a second contact pad 210B, and a solder mask layer 220. Using solder 230, or another electrically conductive attachment material, terminal T1 of semiconductor die 110 is connected to first contact pad 210A, and terminal T2 of semiconductor die 110 is connected to second contact pad 210B.

As shown in figure 2 (top), terminal T1, which is arranged on the p-type doped region above dashed line L1, is connected via solder 230 to the sidewall of semiconductor die 110. There, as indicated by arrow A, it can make contact to the n-type doped region below dashed line L1. Accordingly, a short-circuit is generated between terminals T1 and T2.

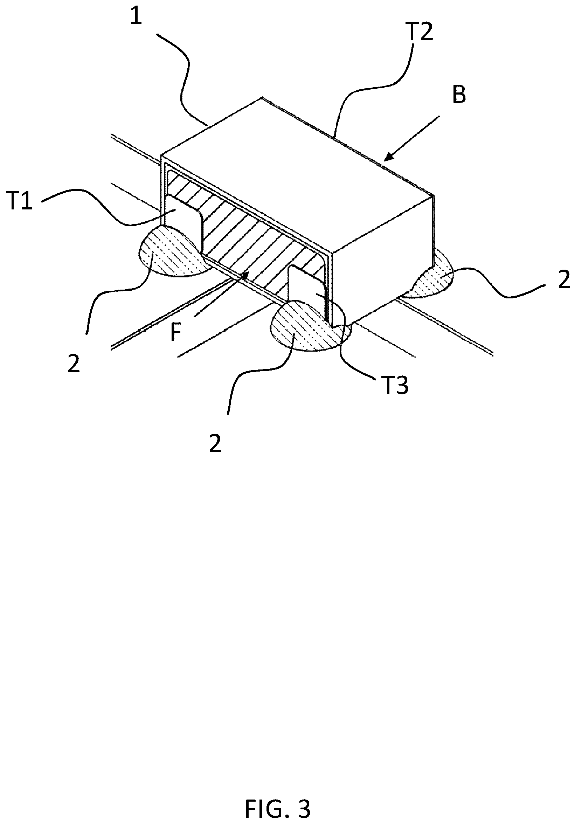

Figure 2 illustrates mounting a two-terminal semiconductor die as a chip-scale package. Figure 3 illustrates an example wherein a three-terminal semiconductor die is mounted as a chip-scale package. Here, a bipolar transistor is shown having two terminals T1, T3 arranged at a frontside F of semiconductor die 1, and one terminal T2 arranged at a backside B of semiconductor die 1. For example, terminals T1, T2, T3 may be connected to the base, emitter, and collector of the bipolar transistor, respectively. Frontside F is provided with a passivation layer, covering frontside F except at the positions of terminals T1, T3, whereas backside B is entirely covered by terminal T2.

The passivation layer is applied prior to dicing or sawing the wafer. Consequently, after dicing or sawing the wafer, the sidewalls of semiconductor die 1 are exposed. Furthermore, even if the passivation layer covered the entire frontside prior to dicing, and was not only present in the inner part of the semiconductor die, the mechanical action associated with sawing may cause at least a portion of the passivation layer to detach from semiconductor die 110 thereby exposing the semiconductor body of the semiconductor die and increasing the risk of electrical short-circuits.

In particular for high-voltage devices, to which aspects of the present disclosure relate, termination structures are arranged around the vertical semiconductor device. These termination structures are typically arranged close to a boundary between the perimeter part and the inner part and serve to prevent premature voltage breakdown occurring near the edges of the device. In figures 2 and 3, in case the solder makes electrical contact with the semiconductor body in the perimeter part of the semiconductor die and/or with the sidewalls, the electric field distribution may be impacted and a reduction in voltage breakdown can be observed. A further performance parameter that is important for high-voltage devices is the leakage current under reverse bias conditions. The Applicant has found that leakage currents generally worsen when the solder makes electrical contact with the semiconductor body in the perimeter part of the semiconductor die and/or with the sidewalls.

In the art, a technique is known for obtaining an electrically insulating layer for electrically insulating sidewalls of a semiconductor die. For example, US2018233426A1 discloses a method for realizing 6-sided (6S) protection of a horizontal device by means of atomic layer deposition, ALD. During deposition, one side of the semiconductor die of the device is arranged on a carrier thereby preventing that the insulating layer would cover the device terminals arranged on that side. However, for vertical devices, a problem exists that the insulating layer would be deposited on the device terminal that is arranged on the other side of the semiconductor die. Accordingly, after deposition, the insulating layer needs to be removed from these terminals.

ALD is a highly conformal deposition technique by which very thin layers can be deposited at relatively low temperatures. The dielectric strength of ALD coatings is generally excellent, allowing good electrical insulation around corners of the semiconductor die and on the sidewalls. Another advantage of ALD coatings is that they provide sufficient strength such that they remain attached to the semiconductor body and do not get damaged during handling or mounting of the semiconductor device.

The Applicant has found that it is very difficult to find a suitable insulating layer that on the one hand offers sufficient mechanical robustness, but which on the other hand can be removed from the device terminal(s) without too many difficulties. For example, although conformal layers obtained using ALD techniques show excellent mechanical robustness, they cannot be removed easily after deposition as these layers are chemically inert, at least to a large extent.

EP3113219A1 discloses a vertical semiconductor device having a mesa-type structure of which the sidewalls are covered by an insulating layer deposited using atomic layer deposition. A sacrificial layer is deposited on the top side prior to depositing this insulating layer. By removing the sacrificial layer, the insulating layer can be removed from the top side thereby exposing electrical terminals on that side.

The semiconductor die that accommodates the vertical semiconductor device disclosed in EP3113219A1 is configured to be mounted with its backside flat on a carrier such as a printed circuit board. Connections to the topside can then be made using conventional means such as bondwires.

The Applicant has found that the method for insulating the sidewalls disclosed in EP3113219A1 is not suitable for enabling a semiconductor die to be used as a chip-scale package.

### SUMMARY

According to an aspect of the present disclosure, a method for manufacturing a semiconductor device, such as a chip-scale package, is provided in which the abovementioned problems do not occur or at least to a lesser extent. This method comprises providing a plurality of semiconductor dies arranged on a carrier, wherein the semiconductor dies have a first surface by which they are arranged on the carrier and a second surface opposite to the first surface.

The semiconductor dies each comprise an inner part and a perimeter part surrounding the inner part, wherein the semiconductor dies each comprise, in the perimeter part, at least a remainder of a sawing line or dicing street that was or is to be used for singulating the semiconductor dies from other semiconductor dies on a semiconductor wafer, and a semiconductor vertical device realized inside the inner part. A passivation layer is arranged in at least the inner parts of the semiconductor dies.

Each semiconductor die comprises at least one first terminal arranged at its first surface, at least one second terminal that is arranged at the second surface in its inner part and that is at least partially exposed through one or more openings in the passivation layer, and sidewalls between the first and second surfaces.

According to an aspect of the present disclosure, a sacrificial layer is provided at the second surfaces of the semiconductor dies, wherein the sacrificial layer at least partially covers the at least one second terminals, and comprises first openings aligned with spaces between adjacent semiconductor dies, and second openings at least partially aligned with the perimeter parts of the semiconductor dies. The first and second openings can be merged.

The method further comprises arranging a conformal coating on the semiconductor dies through the first and second openings.

Furthermore, the method comprises removing the conformal coating arranged on the sacrificial layer by removing the sacrificial layer. The conformal coating that has remained on the semiconductor dies covers the perimeter parts of the semiconductor dies and covers the sidewalls of the semiconductor dies at least partially. The semiconductor dies made in this manner can be used as a chip-scale package.

The conformal coating should preferably at least cover those regions of the perimeter parts where the semiconductor body of a semiconductor die would otherwise be exposed. In some embodiments, the perimeter parts are fully covered by the conformal coating.

According to an aspect of the present disclosure, the conformal coating that is arranged over the second terminals is removed not by chemically engaging the conformal coating directly, for example using etching techniques, but by removing the underlying sacrificial layer. In this manner, an insulating layer, namely the conformal coating, can be used that has excellent mechanical robustness even though this insulating layer by itself is substantially chemically inert. In general, the insulation layer will comprise multiple layers of different materials. As an example, the insulating layer will comprise an alternating stack of two different materials.

Because the conformal coating covers both the perimeter part and the sidewalls, there cannot be any direct contact between the solder or other electrically conductive attaching material, and exposed parts of the semiconductor die at the sidewalls and/or second surface. In this manner, short-circuits as the ones shown in figure 1 and 2 can be avoided. Furthermore, because no direct contact exists between the solder and the sidewalls, the electric field distribution will not disturbed when mounting the semiconductor die.

The conformal coating that remains on the semiconductor dies may at least partially cover the inner parts of the semiconductor dies. Furthermore, the conformal coating may comprise one or more openings through which the at least one second terminals are at least partially exposed. A surface area of the one or more openings through which the at least one second terminals are at least partially exposed can be less than a surface area of the at least one second terminals. For example, at least one second terminal may extend underneath the conformal coating, preferably on all sides of the at least one second terminal. Furthermore, the conformal coating that has remained on the semiconductor dies may at least partially cover the passivation layer. The one or more openings in the conformal coating that has remained on the semiconductor die can be aligned with the one or more openings in the passivation layer for the purpose of exposing the at least one second terminals. Preferably, the one or more openings in the conformal coating are larger than, preferably on all sides, said one or more openings in the passivation layer.

The perimeter parts may not or not fully be covered by the passivation layer. This avoids the uncontrolled break-off of parts of the passivation layer during sawing or dicing. The passivation can be one or more of the group consisting of silicon nitride, silicon oxide, and silicon oxynitride.

The plurality of semiconductor dies may correspond to a diced semiconductor wafer arranged on the carrier. The diced wafer may correspond to a partially-cut diced wafer, such as a half-cut diced wafer, in which the dies are still interconnected through a part of the semiconductor wafer. Alternatively, the diced wafer may correspond to a full-cut diced wafer in which the semiconductor dies have been physically separated. However, the present disclosure does not exclude embodiments in which the semiconductor dies have been arranged on the carrier without belonging to one wafer. For example, the semiconductor dies may have been arranged on the carrier using a pick-and-place apparatus.

The conformal coating may be arranged by performing atomic layer deposition. Performing atomic layer deposition may comprise using trimethylaluminum and water, and titanium tetrachloride and water, as precursor pairs. Using these precursor pairs, an alternating layer stack of Al₂O₃ and TiO₂ can be deposited.

The sacrificial layer may be arranged on the semiconductor dies while still being interconnected in a wafer before dicing. For example, the sacrificial layer may be arranged on the semiconductor dies, for example by means of deposition, spin-coating, evaporation, inkjet printing or stencil printing, while still being interconnected in a wafer and before arranging this wafer on the carrier. The sacrificial layer may be chosen from the group consisting of photoresist, polymers, thin metal layers, self-assembled monolayers, and/or combinations thereof. In addition, the method may comprise arranging and patterning a masking layer on the sacrificial layer and removing the sacrificial layer through openings in the masking layer. In the regions of the semiconductor dies that correspond to these openings, the conformal coating will not be removed at a later stage as no sacrificial layer is present underneath the conformal coating in these regions.

The at least one second terminals can be formed using a metal layer stack that comprises a plurality of metal layers, wherein the sacrificial layer is formed by one or more metal layers that are arranged farthest from the second surface or a part thereof. This metal layer stack may for example comprise TiNiVAg, NiAu, Ni, Al, TiNiAg, AuNiAg, AuAsNiAg, and/or combinations thereof. By removing the one or more metal layers or a part thereof that form(s) the sacrificial layer, the conformal coating directly above the sacrificial layer will be removed, and the remaining metal layers will form the at least one second terminals. Furthermore, also in this case, the process of wafer dicing will cause openings to be formed in the sacrificial layer.

The sacrificial layer may be removed by ablating the sacrificial layer by means of photo-ablation. In this case, the sacrificial layer is illuminated using light having a suitable wavelength, pulse duration, and/or power. The energy contained in the light is transformed inside the sacrificial layer into heat. Due to the generated heat, the sacrificial layer will ablate violently thereby also breaking the conformal coating that the sacrificial layer is in contact with. Typically, the light is provided in a substantial uniform manner. In some embodiments, more in particular those in which the presence of the sacrificial layer does not influence the mechanical or electrical behavior of the semiconductor die, the light may not be provided uniformly. Rather the light may be patterned for example using a photomask or shadow mask and using standard exposure techniques. In this manner, the sacrificial layer can be removed locally.

The present disclosure does not exclude other means of removing the sacrificial layer provided that these means do not disturb or damage the other components of the semiconductor die. For example, removing the sacrificial layer may comprise providing a thermal shock to the sacrificial layer and conformal coating causing the conformal coating and sacrificial layer to mutually delaminate. The delaminated conformal coating, which as a result of applying the thermal shock may be in the form of flakes, is subsequently removed. The sacrificial layer is preferably a photo-sensitive layer, such as photoresist. In this case, the thermal shock can be provided by means of applying optical energy for example using a laser source. A cleaning step, such as cleaning plasma, can optionally be performed for removing the remaining sacrificial layer.

Alternatively, removing the sacrificial layer may comprise performing a grinding, dicing, cutting or other mechanical operation for removing the sacrificial layer and the conformal coating covering that layer. In this case, the conformal coating and sacrificial layer are physically engaged. A cleaning step, such as cleaning plasma, can optionally be performed for removing the remaining sacrificial layer.

Instead of the sacrificial layer being part of a metal stack or being deposited, the sacrificial layer may also be formed by attaching a first foil to the second surface of the semiconductor dies. The first foil can be provided with the abovementioned first and second openings. When using the first foil as the sacrificial layer, the sacrificial layer may be removed by removing the first foil from the second surface. If the first foil comprises openings that are arranged on the at least one second terminals, conformal coating may still be present on the at least one second terminals after having removed the first foil. Provided sufficient terminal area remains uncovered by the conformal coating, the electrical characteristics of an electrical contact to such terminal is not or hardly affected.

The carrier may comprise a second foil. This second foil may be a dicing foil. Furthermore, the second foil may comprise a plurality of openings to allow the conformal coating to be formed on the sidewalls through the openings. After arranging the conformal coating, the semiconductor dies and the second foil can be separated. This may for example be done during a pick-and-place process in which the semiconductor dies are picked from the second foil. If the second foil comprises openings that are arranged on the at least one first terminal, conformal coating may still be present on the at least one first terminal after having removed the second foil. Provided sufficient terminal area remains uncovered by the conformal coating, the electrical characteristics of an electrical contact to such terminal is not or hardly affected.

According to a further aspect of the present disclosure, a semiconductor device such as a chip-scale package is provided that comprises a semiconductor die having an inner part and a perimeter part surrounding the inner part, wherein the semiconductor die comprises, in the perimeter part, at least a remainder of a sawing line or dicing street that was used for singulating the semiconductor die from other semiconductor dies on a semiconductor wafer, and a semiconductor vertical device realized inside the inner part, wherein a passivation layer is arranged in at least the inner part of the semiconductor die.

The semiconductor die comprises a first surface, and a second surface opposite to the first surface. The semiconductor die comprises at least one first terminal arranged at its first surface, at least one second terminal that is arranged at its second surface and that is at least partially exposed through one or more openings in the passivation layer, and sidewalls extending between the first and second surfaces.

The semiconductor die further comprises a conformal coating covering the perimeter part and at least a part of the sidewalls to prevent a short-circuit from occurring between the at least one first terminal and the at least one second terminal when mounting the semiconductor device on a carrier. The conformal coating can at least partially cover the inner part, wherein the conformal coating comprises one or more openings through which the at least one second terminal is at least partially exposed. A surface area of the one or more openings through which the at least one second terminal is at least partially exposed can be less than a surface area of said at least one second terminal. For example, at least one second terminal may extend underneath the conformal coating, preferably on all sides of the at least one second terminal.

The conformal coating can at least partially cover the passivation layer. The one or more openings in the conformal coating can be aligned with the one or more openings in the passivation layer for the purpose of exposing the at least one second terminal. Preferably, the one or more openings in the conformal coating are larger, preferably on all sides, than said one or more openings in the passivation layer.

The perimeter part may not or not fully be covered by the passivation layer. This avoids the uncontrolled break-off of parts of the passivation layer during sawing or dicing. In an embodiment, the passivation layer is provided in the perimeter part of a segment prior to dicing for up to 50 percent of the area of the perimeter part, preferably up to 25 percent. For a semiconductor die obtained after dicing or sawing, the passivation layer is provided in the perimeter part for up to 75 percent of the area of the perimeter part, preferably up to 50 percent. As stated above, embodiments are also possible in which the passivation layer is not provided in the perimeter part. The passivation layer can be one or more of the group consisting of silicon nitride, silicon oxide, and silicon oxynitride.

The at least one first terminal and/or second terminal can be provided with a plurality of islands comprising the conformal coating. These islands are for example formed when a first foil is used that comprises openings formed over the at least one second terminal as described above. The at least one first terminal may cover the first surface in its entirety.

The conformal coating may comprise a coating obtained by atomic layer deposition, and preferably comprises an alternating arrangement of Al₂O₃ and TiO₂ layers. This combination of layers provides protection against chemicals in the soldering and gluing process, as well as moisture and ionic contamination. In addition, it offers high electric breakdown strength and constitutes a good electrical insulator. The semiconductor vertical device may be a device chosen from the group consisting of trench MOSFETs, planar MOSFETs, PN diodes, Schottky diodes, Zener diodes, and bipolar junction transistors. Additionally, or alternatively, the semiconductor die may comprise a conductive semiconductor substrate, such as an n-type or p-type doped wafer substrate.

The semiconductor device may comprise a normal direction that extends perpendicular to and from the first surface to the second surface. The semiconductor device can be configured to be arranged on a carrier, such as a printed circuit board, with its normal direction parallel to the carrier, wherein the at least one first terminal is configured to be connected to at least one first contact pad on the carrier and wherein the at least one second terminal is configured to be connected to at least one second contact pad on the carrier.

According to a further aspect, the present disclosure provides a system that comprises a carrier, such as a printed circuit board, comprising at least one first contact pad and at least one second contact pad spaced apart from the at least one first contact pad. The system further comprises the semiconductor device as described above that is mounted to the carrier with its normal direction parallel to the carrier. The at least one first terminal is electrically connected to the at least one first contact pad using electrically conductive attaching material, and the at least one second terminal is electrically connected to the at least one second contact pad using electrically conductive attaching material. The electrically conductive attaching material can be one or more of the group consisting of solder, conductive glue, and silver sinter material.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates a known chip-scale package;
Figure 2 illustrates mounting the chip-scale package;
Figure 3 illustrates a known chip-scale package that is mounted to a carrier illustrating the problem of a short-circuit occurring between a device terminal and a sidewall of the semiconductor die of the chip-scale package;
Figure 4 illustrates a chip-scale package in accordance with an aspect of the present disclosure that is mounted to a carrier;
Figure 5A and 5B schematically illustrate two different embodiments of a chip-scale package in accordance with an aspect of the present disclosure;
Figures 6-9 illustrate four methods for manufacturing a chip-scale package in accordance with various aspects of the present disclosure; and
Figure 10 illustrates various configurations for openings in the passivation layer and conformal coating in accordance with various aspects of the present disclosure.

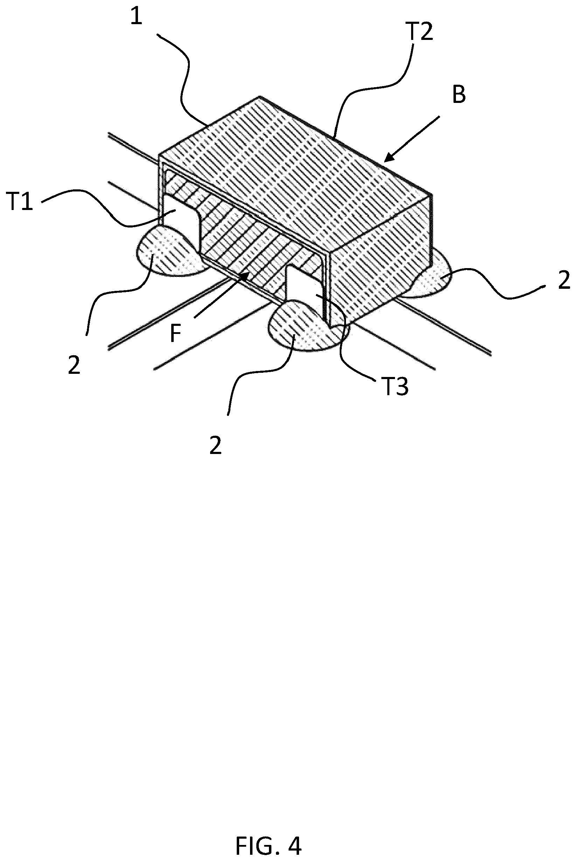

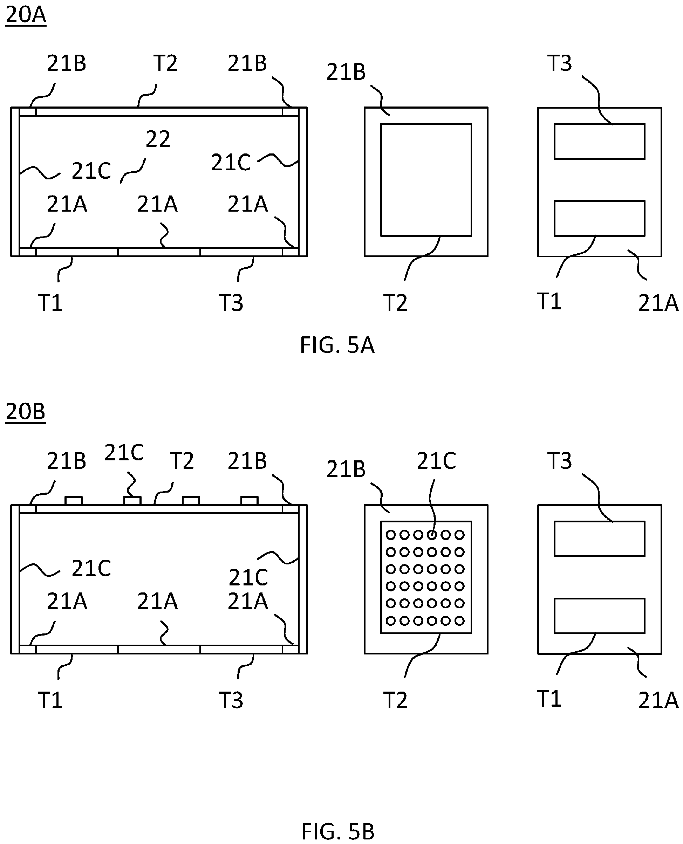

Figure 4 illustrates a chip-scale package that is mounted to a carrier in accordance with an aspect of the present disclosure. Compared to the chip-scale package shown in figure 3, it can be observed that sidewalls of semiconductor die 1 are now covered by a conformal coating as indicated by the hashing, while terminals T1 and T3 are not covered by this coating. A more detailed explanation on this and other chip-scale packages will be provided referring to figures 5A and 5B that schematically illustrate two different embodiments of a chip-scale package in accordance with an aspect of the present disclosure.
Figure 5A illustrates an embodiment of a three-terminal chip-scale package 20A in accordance with an aspect of the present disclosure. Package 20A comprises a semiconductor die 22 having a first surface at which terminals T1, T3 are arranged, and a second surface at which a terminal T2 is arranged.

In the cross-sectional view on the left it can be observed that the sidewalls of semiconductor die 22 are covered with a conformal coating 21C. As shown in the center figure, a passivation layer 21A is arranged on a bottom surface adjacent terminals T1, T3. This passivation layer comprises one or more insulation layers, such as silicon oxide or silicon nitride, on which conformal coating 21C can be arranged. Similarly, on the front surface, a passivation layer 21B is arranged adjacent terminal T2. This passivation layer comprises one or more insulation layers, such as silicon oxide or silicon nitride, and may have conformal coating 21C arranged thereon as well.

The top view in the center illustrates that terminal T2 is surrounded by passivation layer 21B. In some embodiments, terminal T2 is covered on a perimeter area thereof by passivation layer 21B, exposing only a center area of terminal T2. In other embodiments, terminal T2 covers the entire top surface of semiconductor body 22. In such embodiments, passivation layer 21B is absent.

The bottom view on the right illustrates that terminals T1, T3 are surrounded by passivation layer 21A. In some embodiments, terminals T1, T3 are covered on a perimeter area thereof by passivation layer 21A, exposing only a center area of terminals T1, T3.

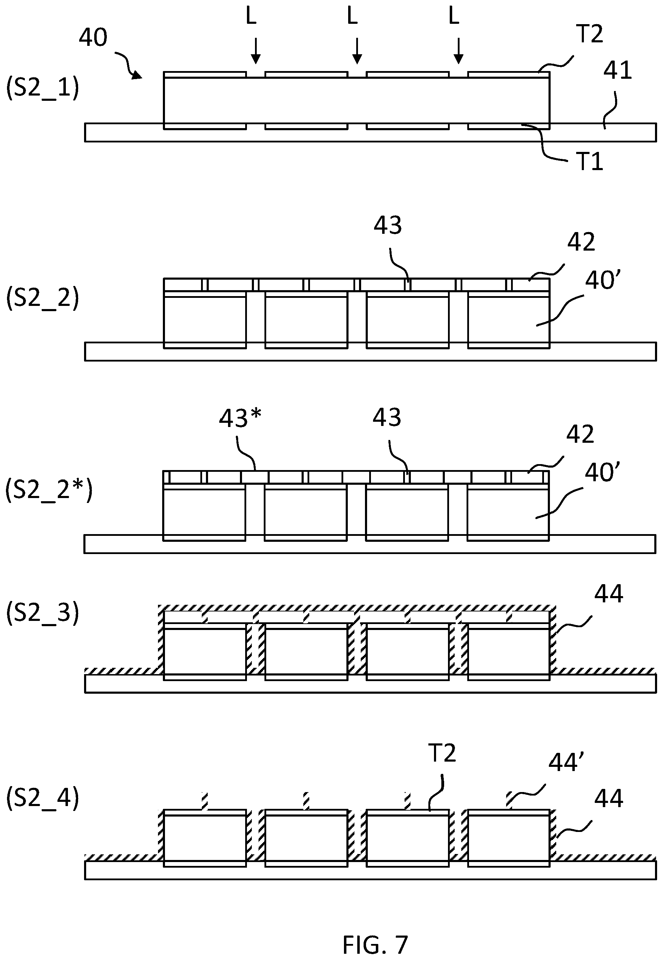

Figure 5B illustrates a further embodiment of a chip-scale package 20B in accordance with an aspect of the present disclosure. Package 20B differs from package 20A in that terminal T2 is covered by small islands of conformal coating 21C. These islands may be the result of using the method of manufacturing a chip-scale package as will be described in connection with figure 7.

Although figures 5A, 5B illustrate three-terminal devices, the present disclosure is not limited thereto. Devices having two or more than three terminals equally fall within the scope of this disclosure.

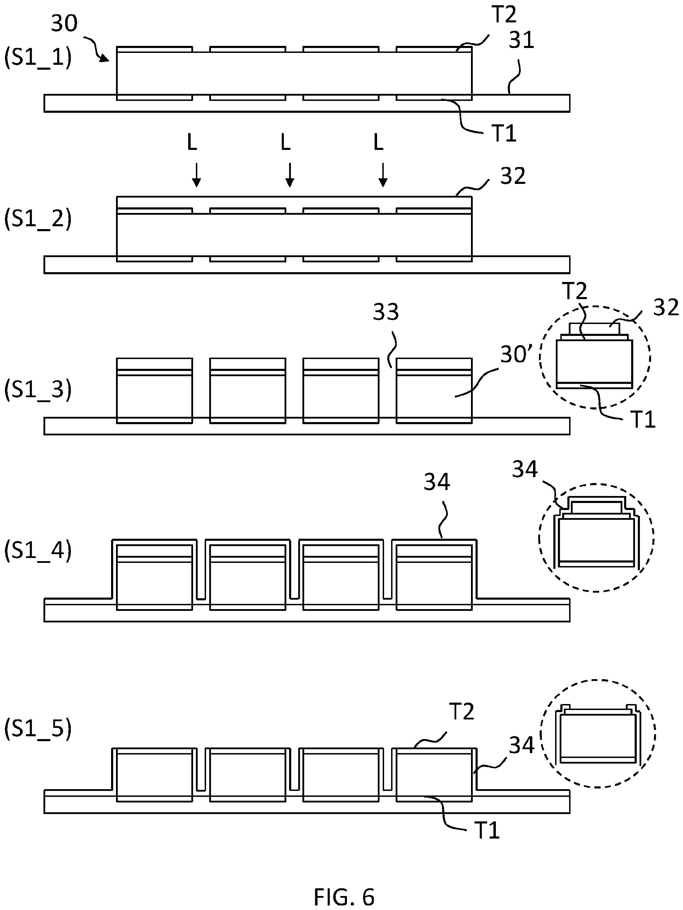

Figure 6 illustrates a first method for manufacturing a chip-scale package in accordance with an aspect of the present disclosure. As a first step, shown as S1_1, a wafer 30 is provided in which a plurality of two-terminal vertical devices is integrated. Each two-terminal device comprises a first terminal T1 arranged at a first surface of wafer 30 and a second terminal T2 arranged at a second surface of wafer 30. Each terminal T1, T2 is configured to cover the entire backside and frontside of the semiconductor die, respectively. Wafer 30 is arranged on a dicing foil 31 in such a manner that dicing foil 31 completely covers terminal T1. For example, terminal T1 can be pressed into dicing foil 31, as shown, or terminal T1 can fully lie against dicing foil 31.

As a next step, shown as S1_2, a sacrificial layer 32 is deposited at the second surface of wafer 30 thereby covering terminals T2. Sacrificial layer 32 may for example comprise photoresist, inks, pastes other materials with good heat absorption and a low evaporation point.

As a next step, shown as S1_3, wafer 30 is diced along dicing lines L. As a result of the dicing process, openings 33 are created in between the different semiconductor dies 30' that correspond to different packages.

In a next step shown as S1_4, a conformal coating 34 is applied using atomic layer deposition through openings 33. Here, an alternating stack of Al₂O₃ and TiO₂ layers is formed. In a next step shown as step S1_5, after depositing the alternating layer stack, sacrificial layer 32 is removed by means of photo-ablation. To this end, semiconductor dies 30' may be illuminated using light having a suitable wavelength such that sacrificial layer 32 absorbs the energy and heats up quickly. Finally, sacrificial layer 32 or a part thereof ablates from semiconductor dies 30' taking a part of conformal coating 34 with it. More in particular, the part of conformal coating 34 that is directly connected to sacrificial layer 32 will be removed together with at least a part of sacrificial layer 32 during the photo-ablation. For example, only a few nanometer of the sacrificial layer will be removed, e.g. ablated or evaporated, taking conformal coating 34 with it. After this step, the remaining part of sacrificial layer 32, if any, could be removed using a cleaning step for example using a plasma cleaning process.

As shown, after photo-ablation, sidewalls of semiconductor dies 30' are covered by conformal coating 34 while terminals T1, T2 are free of such coating.

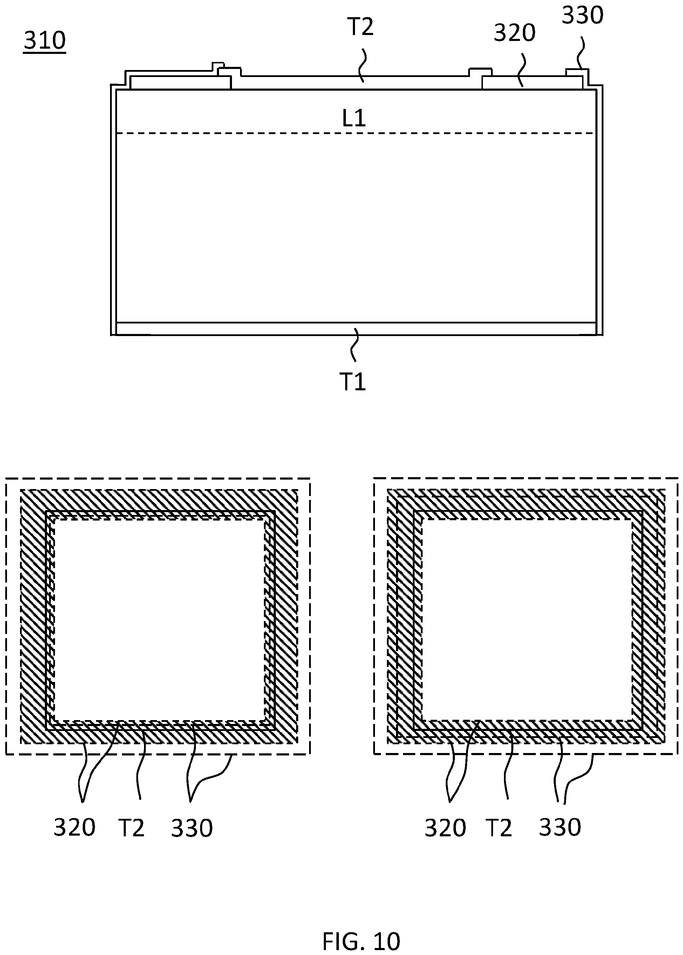

In figure 6, as well as figures 7-9, terminal T2 is shown as entirely covering the second surface of wafer 30. However, the present disclosure is not limited thereto. For example, as shown in the hashed circles, embodiments are equally possible in which terminal T2 does not entirely cover the second surface of wafer 30. For example, the semiconductor die of the package may comprise an inner part and a perimeter part as shown in figure 1. In this case, sacrificial layer 32 may be patterned, for example using lithography techniques for creating openings that allow the ALD coating 34 to cover at least the perimeter parts of the semiconductor dies. These lithography steps can be performed prior to dicing the wafer. After performing ALD, conformal coating 34 may also cover part of terminal T2. As shown in the bottom circle, after having removed sacrificial layer 32, conformal coating 34 will cover a circumferential area of terminal T2. Furthermore, the semiconductor die may be provided with a passivation layer that can also be partially covered by conformal coating 34. This will be explained in more detail in figure 10.

Figure 7 illustrates a second method for manufacturing a chip-scale package in accordance with an aspect of the present disclosure. As a first step, shown as S2_1, a wafer 40 arranged on dicing foil 41 is provided in which a plurality of two-terminal devices is integrated. This step is similar to step S1_1 shown in figure 6.

As a next step, shown as S2_2, wafer 40 is diced along dicing lanes L that are arranged on wafer 40. Furthermore, after dicing, a foil 42 is arranged on the second surface thereby covering terminals T2. Foil 42 comprises openings 43 that are not only arranged above the openings created during the dicing process but also above terminals T2.

As a next step, shown as S2_3, a conformal coating 44 is applied using atomic layer deposition through openings 43. Here, an alternating stack of Al₂O₃ and TiO₂ layers is formed. In a next step, shown as S2_4, after depositing the alternating layer stack, foil 42 is removed from wafer 40. By removing foil 42, coating 44 that is arranged on and in foil 42 is also removed. Compared to figure 6, step S1_5, it can be observed that islands 44' of conformal coating 44 may remain attached to terminal T2. It is further noted that the figures are not true to scale. For example, islands 44' of conformal coating 44 may have a diameter that is substantially larger than a height of conformal coating 44.

In addition to openings above the spaces between adjacent semiconductor dies that have been created as a result of the dicing process, foil 42 may also comprise openings that are aligned with the perimeter parts of the semiconductor die as illustrated in figure 1. This is shown as step S2_2^{∗}. In this figure, the openings that are arranged the spaces between adjacent dies are merged with the openings above the perimeter parts of the semiconductor dies. These merged openings are referred to as openings 43^{∗}. As a result of these openings, conformal coating will also cover the perimeter parts. This can be combined with terminals T2 being exposed through one or more openings in a passivation layer on the semiconductor dies. In such case, the conformal coating may cover the semiconductor body in the perimeter part of the semiconductor die either directly or via the passivation layer, and it may cover the passivation layer that extends over terminals T2.

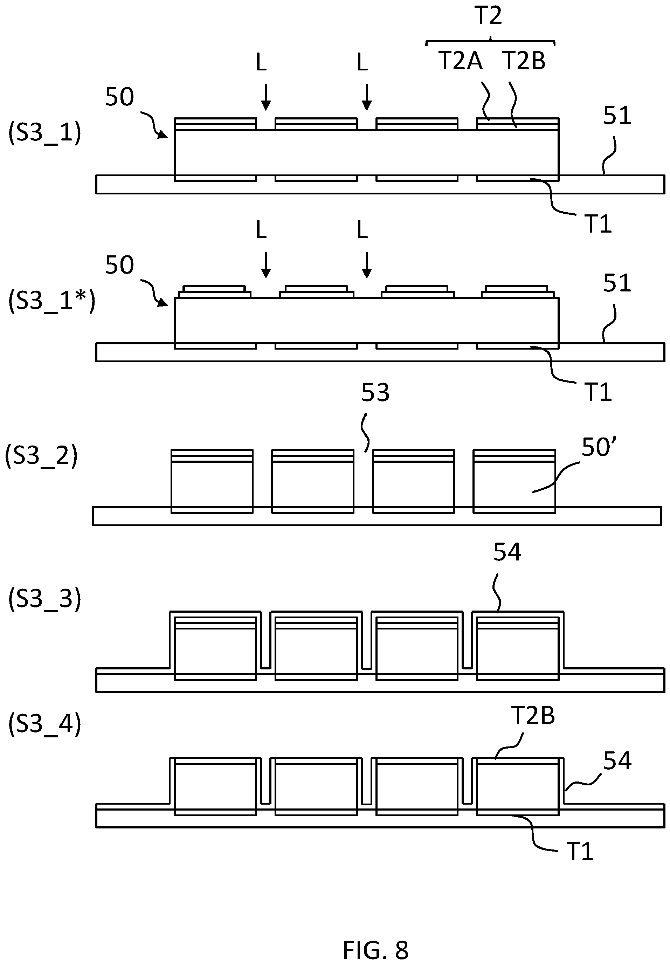

Figure 8 illustrates a third method for manufacturing a chip-scale package in accordance with an aspect of the present disclosure. As a first step, shown as S3_1, a wafer 50 arranged on a dicing foil 51 is provided in which a plurality of two-terminal devices is integrated. This step differs from steps S1_1, S2_1 in that terminal T2 is formed using a metal layer stack comprising an upper part T2A and a lower part T2B. Here, upper part T2A or a part thereof forms a sacrificial layer. Lower part T2B may comprise for example TiNiVAg, TiNiAg, AuNiAg, AuAsNiAg, or combinations thereof, and upper part T2A may comprise for example Ag. In general, other metals also displaying low evaporation temperatures in combination with a high absorption of light energy for the wavelength of the light source used for the photo-ablation can be employed.

As a next step, shown as S3_2, wafer 50 is diced along dicing lanes L that are arranged on wafer 50. In between upper parts T2A openings 53 can be identified. In some embodiments, terminal T2 is formed to cover the entire second surface of wafer 50 prior to dicing. In such case, the dicing process will create openings 53 instead of the openings in the sacrificial layer already being present prior to dicing wafer 50.

As a next step, shown as S3_3, a conformal coating 54 is applied using atomic layer deposition through openings 53. Here, an alternating stack of Al₂O₃ and TiO₂ layers is formed. in a next step shown as S3_4, after depositing the alternating layer stack, upper part T2A or a part thereof is removed by means of photo-ablation. To this end, semiconductor dies 50' may be illuminated using light having a suitable wavelength such that upper part T2A absorbs the energy and heats up quickly. Finally, upper part T2A ablates from semiconductor dies 50' either partly or fully taking a part of conformal coating 54 with it. More in particular, the part of conformal coating 54 that is directly connected to upper part T2A will be removed together with at least a part of upper part T2A during the photo-ablation.

To enable the perimeter part of the semiconductor die and/or terminal T2 to be at least partially covered by conformal coating 54, it may be advantageous to use a terminal T2 that does not cover the entire surface of the semiconductor die. Rather, terminal T2 may be exposed through an opening in a passivation layer, similar to what is shown in figure 1.

Step S3_1^{∗} illustrates an example where the perimeter part of the die and part of terminal T2 are covered by conformal coating 54. This figure does not illustrate a passivation layer that may be used.

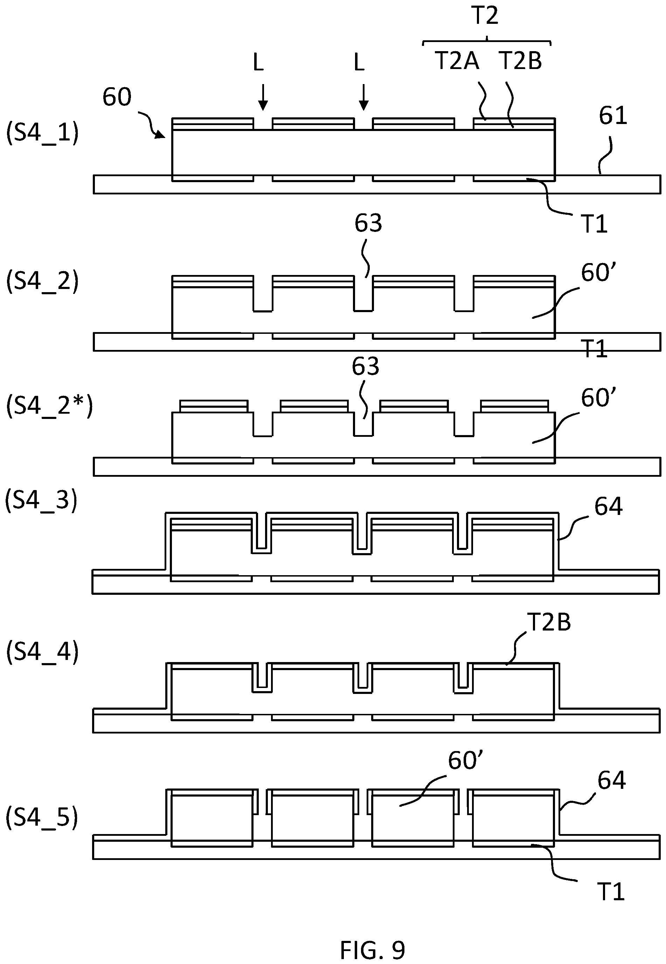

Figure 9 illustrates a fourth method for manufacturing a chip-scale package in accordance with an aspect of the present disclosure. As a first step, shown as S4_1, a wafer 60 arranged on a dicing foil 61 is provided in which a plurality of two-terminal devices is integrated. This step is identical to step S3_1.

As a next step, shown as S4_2, wafer 60 is partially-cut diced, such as half-cut diced, along dicing lanes L that are arranged on wafer 60. Compared to step S3_2, the semiconductor dies remain attached to each other after dicing via a remaining part of wafer 60. In between upper parts T2A openings 63 can be identified. In some embodiments, terminal T2 is formed to cover the entire second surface of wafer 60 prior to dicing. In such case, the dicing process will create openings 63 instead of the openings in the sacrificial layer already being present prior to dicing wafer 60.

As a next step, shown as S4_3, a conformal coating 64 is applied using atomic layer deposition through openings 63. This step is identical to step S3_3. In a next step shown as S4_4, after depositing conformal coating 64, upper part T2A or a part thereof is removed by means of photo-ablation. To this end, semiconductor dies 60' may be illuminated using light having a suitable wavelength such that upper part T2A absorbs the energy and heats up quickly. Finally, upper part T2A ablates from semiconductor dies 60' either partly or fully taking a part of conformal coating 64 with it. More in particular, the part of conformal coating 64 that is directly connected to upper part T2A will be removed together with at least a part of upper part T6A during the photo-ablation.

As a final step, shown as S4_5, semiconductor dies 60' are fully separated, for example using a dry etch. In this method, there is less chance of contamination of the sidewalls during steps S4_3 and S4_4 as wafer 60 itself provides shielding for contaminants coming for instance from dicing foil 61. More in particular, this method can be used to prevent the glue layer of dicing foil 61 from contaminating the sidewalls of semiconductor dies 60' before atomic layer deposition.

To enable conformal coating 64 to cover the perimeter part of semiconductor dies 60' and an optional passivation layer, it is possible to use a different terminal T2 as shown for step S4_2^{∗}.

In figures 6-9, a two-terminal device was discussed. However, the same method of manufacturing can be used for devices comprising more than two terminals. In addition, dicing foil 31, 41, 51,61 may also be provided with openings to allow conformal coating 34, 44, 54, 64 to be formed on the sidewalls of semiconductor dies 30', 40', 50', 60'.

In figures 6, 8 and 9, sacrificial layers 32, T2A are removed using photo-ablation. This light may be provided using a laser that scans over the surface of the diced wafer. Alternatively, a less focused light source may equally be used, for example a light source that illuminates the entire diced wafer at the same time or part of the sample using a shadow mask or other form of light patterning approach. Regardless the method of illumination, it is preferable that the sacrificial layer shows a much higher absorption of the optical energy than other components in the device. Accordingly, the material used as sacrificial layer for photo-ablation must be carefully chosen in connection with the light source that is going to be used. But differently, the sacrificial layer should have a relatively high specificity with respect to the absorption of energy from the external energy source when compared to other layers or components of the device. In this respect, it should be noted that according to another aspect of the present disclosure an energy source other than a light source can be used to cause the ablation of the sacrificial layer.

Furthermore, in figures 6-9, the entire first surface of wafer 30, 40, 50, 60 is covered by dicing foil 31, 41, 51, 61. Alternatively, a small space may exist between wafer 30, 40, 50, 60 and dicing foil 31, 41, 51, 61 in regions away from terminals T1. In such case, conformal coating may also be arranged on the first surface and adjacent to terminals T1.

As shown above, the sacrificial layer can be patterned or otherwise provided in a form in which first openings are provided that are aligned with spaces between adjacent semiconductor dies, and second openings that are at least partially aligned with the perimeter parts of the second surfaces of the semiconductor dies. Possible configurations of these openings are shown in figure 10.

Figure 10 (top) illustrates a cross-section of an embodiment of a chip-scale package 310 in accordance with the present disclosure in which different configurations of the conformal coating have been used.

The left part of package 310 presents a first configuration of the openings in passivation layer 320 and the openings in conformal coating 330. A top view of a semiconductor die that fully uses this configuration is shown on the bottom left. In this first configuration, the opening in conformal coating 330 is larger than the opening in passivation layer 320 for exposing terminal T2, and terminal T2 is itself larger than the opening formed in conformal coating 330 and the opening in passivation layer 320.

The right part of package 310 presents a second configuration of the openings in passivation layer and the openings in the conformal coating. A top view of a semiconductor die that fully uses this configuration is shown on the bottom right. In this second configuration, the opening in conformal coating 330 is larger than the opening in passivation layer 320 for exposing terminal T2, and terminal T2 is itself smaller than the opening formed in conformal coating 330 but larger than the opening in passivation layer 320.

It should be noted that many more configurations are possible in which conformal coating 330 covers the perimeter part of the semiconductor die either directly or via passivation layer to prevent any direct contact between the semiconductor die and electrically conductive attachment material when mounting the chip-scale package that is formed by this semiconductor die.

In the above, the present invention has been described using detailed embodiments thereof. However, the present invention is not limited to these embodiments. Instead, various modifications are possible without departing from the scope of the present invention which is defined by the appended claims and their equivalents.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

1. A method for manufacturing a semiconductor device, such as a chip-scale package, comprising:
providing a plurality of semiconductor dies (30', 40', 50', 60') arranged on a carrier, wherein the semiconductor dies have a first surface by which they are arranged on the carrier and a second surface opposite to the first surface, wherein the semiconductor dies each comprise an inner part and a perimeter part surrounding the inner part, wherein the semiconductor dies each comprise, in the perimeter part, at least a remainder of a sawing line or dicing street that was or is to be used for singulating the semiconductor dies from other semiconductor dies on a semiconductor wafer, and a semiconductor vertical device realized inside the inner part, wherein a passivation layer is arranged in at least the inner parts of the semiconductor dies, wherein each semiconductor die comprises at least one first terminal (T1) arranged at its first surface, at least one second terminal (T2) that is arranged at its second surface in its inner part and that is at least partially exposed through one or more openings in the passivation layer, and sidewalls extending between the first and second surfaces, wherein a sacrificial layer (32; 42; T2A) is provided at the second surfaces of the semiconductor dies, wherein the sacrificial layer at least partially covers the at least one second terminal, and comprises first openings (33; 43; 53; 63) aligned with spaces between adjacent semiconductor dies, and second openings at least partially aligned with the perimeter parts of the second surfaces of the semiconductor dies;
arranging a conformal coating (34; 44; 54; 64) on the semiconductor dies; and
removing the conformal coating arranged on the sacrificial layer by removing the sacrificial layer;
wherein the conformal coating that has remained on the semiconductor dies covers the perimeter parts of the semiconductor dies and covers the sidewalls of the semiconductor dies at least partially.

2. The method according to claim 1, wherein the conformal coating that has remained on the semiconductor dies at least partially covers the inner parts of the semiconductor dies, said conformal coating comprising one or more openings through which the at least one second terminals are at least partially exposed.

3. The method according to claim 2, wherein the conformal coating that has remained on the semiconductor dies at least partially covers the passivation layer.

4. The method according to claim 3, wherein the one or more openings in the conformal coating that has remained on the semiconductor dies are aligned with the one or more openings in the passivation layer for the purpose of exposing the at least one second terminals.

5. The method according to any of the previous claims, wherein the perimeter parts are not or not fully covered by the passivation layer.

6. The device according to any of the previous claims, wherein the passivation layer is one or more of the group consisting of silicon nitride, silicon oxide, and silicon oxynitride.

7. The method according to any of the previous claims, wherein the plurality of semiconductor dies corresponds to a diced semiconductor wafer arranged on the carrier, wherein the diced wafer corresponds to a partially-cut diced wafer, such as a half-cut diced wafer, in which the dies are still interconnected through a part of the semiconductor wafer, or wherein the diced wafer corresponds to a full-cut diced wafer in which the semiconductor dies have been physically separated.

8. The method according to any of the previous claims 1, wherein said arranging a conformal coating comprises performing atomic layer deposition, wherein said performing atomic layer deposition comprises using trimethylaluminum and water, and titanium tetrachloride and water as precursor pairs.

9. The method according to any of the previous claims, wherein said providing a plurality of semiconductor dies comprises arranging the sacrificial layer on the semiconductor dies while still being interconnected in a wafer before dicing;
wherein said providing a plurality of semiconductor dies preferably comprises arranging the sacrificial layer on the second surface of the semiconductor dies while still being interconnected in a wafer and before arranging this wafer on the carrier.

10. The method according to claim 9, wherein said arranging the sacrificial layer on the second surface of the semiconductor dies comprises depositing a layer (32) on the second surface, said layer being chosen from the group consisting of photoresist, polymers, thin metal layers, self-assembled monolayers, and/or combinations thereof.

11. The method according to claim 10, wherein the method further comprises arranging and patterning a masking layer on the sacrificial layer and removing the sacrificial layer through openings in the masking layer.

12. The method according to any of the claims 1-8, wherein the second terminals are formed using a metal layer stack comprising a plurality of metal layers, wherein the sacrificial layer (T2A) is formed by one or more metal layers that are arranged farthest from the second surface or a part thereof, wherein the metal layer stack preferably comprises TiNiVAg, NiAu, Ni, Al, TiNiAg, AuNiAg, AuAsNiAg and/or combinations thereof.

13. The method according to any of the previous claim, wherein said removing the sacrificial layer comprises ablating the sacrificial layer by means of photo-ablation.

14. The method according to any of the claims 1-12, wherein said removing the sacrificial layer comprises:
providing a thermal shock to the sacrificial layer and conformal coating causing the conformal coating and sacrificial layer to mutually delaminate; and
removing the delaminated conformal coating;
wherein the sacrificial layer is preferably a photo-sensitive layer, such as photoresist, and wherein the thermal shock is preferably provided by means of applying optical energy for example using a laser source;
the method optionally comprising performing a cleaning step for removing the remaining sacrificial layer.

15. The method according to any of the claims 1-12, wherein said removing the sacrificial layer comprises performing a grinding, dicing, cutting or other mechanical operation for removing the sacrificial layer and the conformal coating covering that layer by physically engaging the conformal coating and sacrificial layer, the method optionally comprising performing a cleaning step for removing the remaining sacrificial layer.

16. The method according to any of the claims 1-8, wherein said providing a plurality of semiconductor dies comprises attaching a first foil (42) as the sacrificial layer to the second surface of the semiconductor dies, wherein the first foil is provided said with first and second openings (43), and wherein said removing the sacrificial layer comprises removing the first foil from the second surface.

17. The method according to any of the previous claims, wherein the carrier comprises a second foil, wherein the second foil is preferably a dicing foil (31; 41; 51; 61), and/or wherein the second foil preferably comprises a plurality of openings to allow the conformal coating to be formed on the sidewalls through the openings.

18. A semiconductor device, such as a chip-scale package, comprising a semiconductor die, said semiconductor die comprising:
an inner part and a perimeter part surrounding the inner part, wherein the semiconductor die comprises, in the perimeter part, at least a remainder of a sawing line or dicing street that was used for singulating the semiconductor die from other semiconductor dies on a semiconductor wafer, and a semiconductor vertical device realized inside the inner part;
a passivation layer arranged in at least the inner part of the semiconductor die;
a first surface, and a second surface opposite to the first surface, the semiconductor die comprising at least one first terminal arranged at its first surface, at least one second terminal that is arranged at its second surface and that is at least partially exposed through one or more openings in the passivation layer, and sidewalls extending between the first and second surfaces;
a conformal coating (21C) covering the perimeter part and at least a part of the sidewalls to prevent a short-circuit from occurring between the at least one first and the at least one second terminals when mounting the device on a carrier.

19. The device according to claim 18, wherein the conformal coating at least partially covers the inner part of the first surface, said conformal coating comprising one or more openings through which the at least one second terminal is at least partially exposed.

20. The device according to claim 19, wherein the conformal coating at least partially covers the passivation layer.

21. The device according to claim 20, wherein the one or more openings in the conformal coating are aligned with the one or more openings in the passivation layer for the purpose of exposing the at least one second terminal.

22. The device according to any of the claims 18-21, wherein the perimeter part is not or not fully covered by the passivation layer.

23. The device according to any of the claims 18-22, wherein the passivation is one or more of the group consisting of silicon nitride, silicon oxide, and silicon oxynitride.

24. The device according to any of the claims 18-23, wherein the at least one second terminal is provided with a plurality of islands (21C) comprising said conformal coating.

25. The device according to any of the claims 18-24, the conformal coating comprises a coating obtained by atomic layer deposition.

26. The device according to claim 25, wherein the conformal coating comprises an alternating arrangement of Al2O3 and TiO₂ layers.

27. The device according to any of the claims 18-26, wherein the vertical device is a device chosen from the group consisting of trench MOSFETs, planar MOSFETs, PN diodes, Schottky diodes, Zener diodes, and bipolar junction transistors, and/or wherein the semiconductor die comprises a conductive semiconductor substrate, such as an n-type or p-type doped semiconductor substrate.

28. The device according to any of the claims 18-27, wherein the device comprises a normal direction that extends perpendicular to and from the first surface to the second surface, wherein the device is configured to be arranged on a carrier, such as a printed circuit board, with its normal direction parallel to the carrier, wherein the at least one first terminal is configured to be connected to at least one first contact pad on the carrier and wherein the at least one second terminal is configured to be connected to at least one second contact pad on the carrier.

29. A system, comprising:
a carrier, such as a printed circuit board, comprising at least one first contact pad and at least one second contact pad spaced apart from the at least one first contact pad;
the semiconductor device according to claim 28 mounted to the carrier with its normal direction parallel to the carrier;
wherein the at least one first terminal is electrically connected to the at least one first contact pad using electrically conductive attaching material; and
wherein the at least one second terminal is electrically connected to the at least one second contact pad using electrically conductive attaching material.

30. The system according to claim 29, wherein the electrically conductive attaching material is one or more of the group consisting of solder, conductive glue, and silver sinter material.
